(19) Europäisches Patentamt
European Patent Office
Office européen des brevets

(11) **EP 3 601 988 B1**

(12) **EUROPEAN PATENT SPECIFICATION**

(45) Date of publication and mention
of the grant of the patent:
**07.09.2022 Bulletin 2022/36**

(21) Application number: **18716135.1**

(22) Date of filing: **21.03.2018**

(51) International Patent Classification (IPC):
**G01M 7/02** (2006.01)      **G01M 11/08** (2006.01)
**G03F 7/20** (2006.01)      **G01H 1/12** (2006.01)

(52) Cooperative Patent Classification (CPC):
**G01H 1/12; G01M 7/022; G01M 11/08;
G03F 7/70825; G03F 7/70975**

(86) International application number:
**PCT/EP2018/057136**

(87) International publication number:
**WO 2018/172399 (27.09.2018 Gazette 2018/39)**

(54) **METHOD FOR LOCALIZING ASSEMBLY ERRORS**

VERFAHREN ZUR LOKALISIERUNG VON MONTAGEFEHLERN

PORCÉDÉ POUR LA LOCALISATION D'ERREURS DE MONTAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.03.2017   DE 102017204685**

(43) Date of publication of application:
**05.02.2020 Bulletin 2020/06**

(73) Proprietor: **Carl Zeiss SMT GmbH
73447 Oberkochen (DE)**

(72) Inventors:
• **NIEDERHAUSEN, Thomas
73430 Aalen (DE)**
• **FETZER, Christoph
89233 Neu-Ulm (DE)**

(74) Representative: **Lang, Christian
LangPatent Anwaltskanzlei IP Law Firm
Ingolstädter Straße 5
80807 München (DE)**

(56) References cited:
**JP-A- H07 325 628     US-A1- 2003 090 645**

• **SESHADRINATH JEEVANAND ET AL: "Vibration
Analysis Based Interturn Fault Diagnosis in
Induction Machines", IEEE TRANSACTIONS ON
INDUSTRIAL INFORMATICS, IEEE SERVICE
CENTER, NEW YORK, NY, US, vol. 10, no. 1, 1
February 2014 (2014-02-01), pages 340-350,
XP011533994, ISSN: 1551-3203, DOI:
10.1109/TII.2013.2271979 [retrieved on
2013-12-12]**

**Description**

BACKGROUND OF THE INVENTION

FIELD OF THE INVENTION

The present invention relates to a method for localizing assembly errors during the arrangement and/or the assembly of structural elements of microlithographic projection exposure apparatuses.

PRIOR ART

In microlithographic projection exposure apparatuses with which nanostructured and microstructured structural elements of microelectronics and microstructuring technology can be produced, structural elements and components of the projection exposure apparatus must be mounted as isolated from vibrations as possible due to the precision of the arrangement of components that is required for a high resolution of such apparatuses, so that negative influences by externally caused vibrations and thus associated position changes of the structural elements or components are avoided.

Accordingly, optical components in projection exposure apparatuses and in particular in projection lenses of microlithographic projection exposure apparatuses can be installed in a free-swinging carrier frame (optic frame), wherein the carrier frame can be stabilized by actuators that counteract external vibrations. Here, sensors capture movements of the carrier frame with respect to specified reference positions in all six degrees of freedom of movement, with the result that the actuators can be controlled or regulated such that a change in position and/or a change in the spatial orientation of the carrier frame is counteracted.

In vibration-isolated structural elements of this type, such as carrier frames for optical components, it is therefore important for the free-swinging mounting to be maintained uninterruptedly at all times so as to ensure dynamic stabilization and vibration isolation.

JPH07325628A discloses a method for constructing a model of a vibration-isolated element. In this disclosure, the element is suspended by an actuator system allowing 6 degrees of freedom of movement. The actuators excite a rotational vibration around a first axis, which is measured at several points of the elements by a sensor moving along the structure. The point where the sensor registered the least vibration is determined, and the sensor is positioned here for the next measurement. In the next step, a translational vibration is excited, and frequency characteristics are derived. This is repeated for the remaining 4 directions. The method yields estimates of the center of rotation and the mass of the element as well as a dynamic model to predict the vibrational behaviour of the vibration-isolated element in order to improve vibrational compensation.

Accordingly, during mounting, i.e. during the arrangement and/or the assembly of such structural elements, the free mounting of the structural element and the dynamic stabilization and vibration isolation should be prevented from being compromised due to unintended mechanical contact of the free-swinging structural element with a neighbouring component, e.g. if cables or the like inadvertently come into contact with the structural element.

Moreover, incorrectly mounted components on the carrier frame, e.g. screws that have not been tightened, can negatively impact the vibration behaviour of the structural element and thus the dynamic stabilization and vibration isolation, for example if additional sources of vibration are introduced due to a loose arrangement of components. By way of example, incorrectly fastened attachment parts on the carrier frame can result in additional vibrations, with the result that the dynamic stabilization and vibration isolation due to the actuation of the corresponding actuators are made more difficult.

Corresponding assembly errors, such as unintended mechanical contacts at a free-swinging or vibration-isolated structural element or the introduction of additional vibration components due to components having been inadequately fastened can be detected in corresponding structural elements, such as carrier frames for optical components, by the mounted structural element being excited to vibrations via the existing actuators of the active regulation for dynamic stabilization and vibration isolation, wherein the vibration behaviour of the structural element under test as produced by the excitation is captured and compared to a reference behaviour that corresponds to a vibration behaviour of a correctly arranged and mounted structural element. If differences between the captured vibration behaviour produced by the excitation and the reference behaviour of a correctly mounted structural element are ascertained, it is possible to deduce therefrom that an assembly error has occurred.

In assembly errors that are due to mechanical contacts of the free-swinging structural element, frequency shifts of the known natural frequencies of the structural element or attenuations of the corresponding natural frequencies can be observed. Individual parts that have been mounted incorrectly can be detected by additional resonance frequencies in the spectra.

When exciting the structural element to vibrations and capturing possible differences of the excited vibration behaviour of the structural element relative to a reference behaviour, the procedure is that the actuators are actuated alone and in combination with different superpositions of actuations of the actuators over a frequency range in order to excite vibrations with different frequencies and different vibration characteristics and to capture the vibration response of the structural element thereto. This is also referred to as a frequency response measurement.

Although assembly errors can be reliably detected with this method, one problem is that no information or insufficient information relating to the type and in particular relating to the position of the assembly error is provided.

To eliminate the assembly error, it is therefore necessary to perform, for example using endoscopic methods, a complicated investigation of the assembly arrangement, i.e. for example of the optical system arranged on a carrier frame, or the already arranged and mounted structural element must be stripped down step by step so as to uncover assembly errors step-by-step. This is highly time-consuming and expensive and consequently, there is a demand for an improvement of the ascertainment of assembly errors.

DISCLOSURE OF THE INVENTION

OBJECT OF THE INVENTION

It is therefore the object of the present invention to provide a method for localizing assembly errors that permits better identification of the location and/or the type of the assembly error so as to be able to prevent complicated inspections of the already mounted structural element. A corresponding method for localizing assembly errors should be capable of being performed easily and permit targeted correction of the assembly error.

TECHNICAL SOLUTION

Said object is achieved by way of a method for localizing assembly errors having the features of Claim 1 and by way of a computer program according to Claim 10 and, in particular in the field of microlithography, by way of a projection exposure apparatus having the features of Claim 11. Advantageous design embodiments are the subject matter of the dependent claims.

The present invention is based on the finding that assembly errors, such as components that have been incorrectly arranged or components that erroneously rest on a free-swinging structural element, have different influences on the vibration behaviour produced by the vibration excitation, depending on the orientation of the observed vibration with respect to the assembly error. By way of example, if a vibration about an axis of rotation is observed, an assembly error that is assigned directly to the axis of rotation will have no major effects on the excited vibration behaviour, while an assembly error that is situated at a distance from the axis of rotation will have a major influence on the excited vibration behaviour of the structural element due to the given torque. Consequently, in the case of a vibration about an axis of rotation, an extrinsic structural element resting on the structural element to be investigated directly at the axis of rotation will have effects on the excited vibration behaviour that are not as great as if the resting extrinsic structural element were situated at a distance from the axis of rotation. In the same way, inadequate tightening of a screw connection at the axis of rotation will have less effect on the excited vibration behaviour than an insufficiently tightened screw connection that is located at a distance from the axis of rotation and correspondingly exhibits a torque with respect to the axis of rotation. In addition to undesired contacts of structural elements or incorrectly mounted structural elements, it is also possible to capture missing or additional masses, such as missing components or the like, in this way.

Accordingly, localization of an assembly error can be performed by first exciting the structural element to be investigated to vibrations in accordance with known frequency response measurements, specifically to vibrations with respect to axes of vibration in at least three independent spatial directions, and capturing the vibration behaviour of the excited structural element. The excitation of the structural element to be investigated advantageously can be performed for example by actuators that are already situated at the vibration-isolated structural element for dynamic stabilization or regulated vibration isolation. Capturing the vibration behaviour of the excited structural element can be done by sensors that are preferably already provided at the corresponding structural element for controlling and/or regulating the actuators in a structural element with dynamic position stabilization and orientation stabilization.

After the excited vibration behaviour of the structural element has been captured, said captured vibration behaviour can be compared to a reference behaviour that corresponds to the vibration behaviour of an identically excited, correctly mounted structural element. By comparing the captured vibration behaviour to the reference behaviour, it is possible to determine whether a deviation has occurred that suggests that an assembly error is present. In this context, a limit value can be defined that must be exceeded by the deviation in order for it to be identified as a deviation.

The above-mentioned steps of the method including the excitation of the structural element to be investigated to vibrations, capturing the vibration behaviour of the excited structural element and comparing the captured vibration behaviour to a reference behaviour and also determining a deviation is repeated multiple times, wherein the vibration excitation is performed with respect to different independent spatial directions. Since the vibration excitation takes place in different orientation with respect to a possible assembly error, the captured vibration behaviour is characterized differently by the assembly error, and by identifying the minimum and/or maximum deviation of the induced vibration behaviour from the reference behaviour in dependence on the vibration excitation with respect to different spatial directions, it is possible to localize the assembly error.

By way of example, if in a first run-through of the method a vibration excitation is performed in a manner such that the x-, y- and z-axes of a Cartesian coordinate system serve as the axes of rotation for rotational vibrations, and if in a second run-through a vibration excitation is performed in a manner such that the x'-, y'- and z'-axes of a different Cartesian coordinate system are used as axes of rotation for a rotational vibration, it is possible to deduce how the assembly error is arranged relative to the different axes of rotation by comparing the ascertained deviations. With a large number of excitations with different axes of rotation and a corresponding comparison of the captured vibration behaviour to said different axes of rotation, it is possible to determine the location of the assembly error.

In order to avoid the complexity for performing a large number of frequency behaviour measurements with different characteristics of the vibration excitation, it is possible to mathematically evaluate the captured values with respect to the vibration behaviour of the structural element from an excitation of the structural element to be investigated to vibrations with respect to axes of vibration in at least three independent spatial directions such that the captured vibration behaviour is evaluated with respect to a large number of fictitious axes of vibration in order to obtain information relating to the position and/or type of the assembly error in this way. In this variant, no additional frequency response measurements are thus necessary; rather, the already available data of a frequency response measurement with the excitation of the structural element to be investigated to vibrations with respect to three independent spatial axes are merely additionally evaluated to not only indicate that an assembly error is present in the first place, but also to effect the localization of the assembly error. Due to the fact that the captured vibration behaviour is analyzed in terms of what the captured vibration behaviour is like with respect to a large number of fictitious axes of vibration, it is possible to identify a fictitious axis of vibration having a minimum or maximum deviation from the reference behaviour, with the result that the assembly error can be localized proceeding from said information. By way of example, it is possible to ascertain, in an evaluation of the captured vibration behaviour with respect to a large number of fictitious axes of rotation, at which fictitious axis of rotation the deviation of the captured vibration behaviour from a reference behaviour is minimum. This fictitious axis of rotation then indicates that the assembly error must be situated on this axis of rotation. Hereby, localization of the assembly error is possible.

The excitation to vibrations in the first method step (method step a)) can in particular comprise the excitation to rotational vibrations about three independent spatial directions, that is to say for example about axes of rotation along the independent spatial axes of a Cartesian coordinate system. Additionally or alternatively, excitations to translational vibrations can be provided, wherein in the case of exclusive excitations to translational vibrations, translational vibrations in three independent spatial directions can be performed, while in the case of an additional excitation to translational vibrations, it is possible, in addition to the already performed excitations to rotational vibrations, for the translational vibrations to be performed merely in at least one spatial direction. It is of course also possible in a corresponding fashion for rotational vibrations about at least one axis of rotation to be excited in addition to translational vibrations in three independent spatial directions. Overall, a diverse combination of different vibration excitations with respect to different types of vibrations is possible.

Accordingly, for the evaluation of the captured vibration behaviour, the evaluation can be effected with respect to a large number of fictitious axes of rotation and/or axes of translation.

The large number of the fictitious axes of vibration that are used for the evaluation of the captured vibration behaviour of the excited structural element are defined by the fact that they extend through the centre of mass of the structural element under investigation and have spherical coordinates with an azimuth angle $\varphi$ between 0 and $2\pi$ and a polar angle $\vartheta$ between 0 and $2\pi$. The large number of the fictitious axes of vibration can vary by way of stepwise variation of the azimuth angle $\varphi$ and the polar angle $\vartheta$ by preferably uniform distances between 0 and $2\pi$. By way of example it might be possible to use fictitious axes of vibration with 360 different azimuth angles $\varphi$ and 360 different polar angles $\vartheta$, wherein the distance between the individual fictitious axes of vibration in the direction of the azimuth angle $\varphi$ and of the polar angle $\vartheta$ would in each case be 1°. Increments of the angular variation with fractions of a degree are of course also possible.

In order to further improve the localization of the assembly error, the method can be performed multiple times in succession, wherein in the second run-through or in further run-throughs, the position of the centre of mass of the structural element to be investigated can be changed by adding or removing mass, or the effective point of attack of the forces for the vibration excitation can be changed by superposing excitation forces. As a result, a changed point of origin of the fictitious axis of vibration is obtained in the evaluation of the fictitious axes of vibration, with the result that the point of intersection of the fictitious axes of vibration having minimum or maximum deviation from the reference behaviour, which axes of vibration have been ascertained in the two or more run-throughs with different point of origin for the fictitious axes of vibration, exactly identifies the location of the assembly error. This is also possible in the same way for the alternative with the experimental determination of a corresponding axis of vibration.

In the alternative with the change in the effective point of attack during the repeated performance of the method, the position of the centre of mass is effectively changed by superposition of the excitation forces without changing the structural element to be investigated, since the superposition of excitation forces of the actuators brings about a fictitious displacement of the centre of mass.

The ratio of the amplitude of the captured vibration behaviour at a specific frequency to the amplitude of the reference behaviour at said frequency can serve as a measure for the deviation of the captured vibration behaviour from the reference behaviour of a correctly mounted structural element. For example, if, in the case of incorrect mounting of a component to the structural element, an additional natural vibration of the system at a specific frequency f is detected, the ratio of the amplitude of the captured vibration at said frequency to the amplitude of the reference at said frequency will indicate an error $\Delta$. The same is true for the case in which an additional attenuation or a shift of a natural frequency occurs due to unintended contact of the structural element to be investigated with an extrinsic structural element. The ratio between the captured amplitude at the corresponding frequency of the captured vibration behaviour to the amplitude of the reference behaviour at said frequency will indicate an error $\Delta$ here as well ($\Delta = a_v{}^{captured} / a_v{}^{reference}$), wherein $a_v{}^{captured}$ is the captured amplitude at the shifted natural frequency v and $a_v{}^{reference}$ is the corresponding amplitude of the reference behaviour at the frequency v.

The frequencies can be chosen in the frequency range from 0,1 Hz to 100 kHz.

The method can be performed in an electronic data processing system, in which a computer program runs that comprises instructions that, upon execution of the program by the computer, causes the latter to perform the method. Accordingly, a computer program and a microlithographic projection exposure apparatus having a control unit in which the computer program for performing the method is executed are also subject matter of the present invention.

The mathematical description can be done as follows:

Mechanical systems are commonly described in the frequency domain by:

$$y = G * u$$

, wherein

y represents the initial values (complex vector), e.g. Shifts, rotation,

u represents the input values (complex vector), e.g. forces, and

G represents the frequency-dependent transmission behavior (complex function).

For a system with several spatial directions, this means:

$$\begin{bmatrix} u_1 \\ u_2 \\ . \\ . \\ . \\ u_m \end{bmatrix}$$

In order to determine the necessary input values and to assess how the system would react to it with regard to its rotation, the following applies:

$$\boldsymbol{u} = \boldsymbol{G^{-1}} * y$$

The division of the input values and output values into rotation and translation yields

$$u = \begin{bmatrix} u_t \\ u_r \end{bmatrix}, \quad u_t = \begin{bmatrix} u_1 \\ \cdot \\ \cdot \\ u_n \end{bmatrix}, \quad u_r$$

$$y = \begin{bmatrix} y_t \\ y_r \end{bmatrix}, \quad y_t = \begin{bmatrix} y_1 \\ \cdot \\ \cdot \\ y_n \end{bmatrix}, \quad y_r$$

It applies:

$$u = \begin{bmatrix} u_t \\ u_r \end{bmatrix} = G^{-1}$$

wherein the parameterization of y is accomplished on the angle φ and θ, that is, the azimuth and polar angles of a spherical coordinate system.

The criterion for determining the deviation from the reference transmission behavior is:

$$\Delta u(\varphi, \theta) = u_{\text{Ref}}(\varphi, \theta) - u_{Fehler}(\varphi, \theta)$$

with

$G^{-1}{}_{r,Ref}$: reference transmission behavior
$G^{-1}{}_{r,Fehler}$: transmission behavior with disturbance

By searching the minimum of Δu, the direction (vector) of the disturbance can be determined:

$$\min_{\varphi, \theta} \| \Delta u(\varphi, \theta) \|$$

Clearly this corresponds to the direction in which the lever of the disturbance is minimal.

As a measure of the determination of the minimum, the 2-norm of Δu can be used. There would also be other standards possible, such as phase relationships.

Subsequently, the center of rotation can be mathematically shifted and the above procedure can be carried out again.

However, a shift of the rotation point also requires translations in the origin, which must be considered in the further calculation.

This leads to the following equation::

$$\Delta u_1(\varphi, \theta) = \left\{ \left( G^{-1}{}_{r,\text{Ref}} + S_1 * G^{-1}{}_{t,\text{Ref}} \right) - \left( G^{-1}{}_{r,\text{Fehler}} + S_1 * G^{-1}{}_{t,\text{Fehler}} \right) \right\} * y_{r,1}(\varphi, \theta)$$

$$\min_{\varphi, \theta} \| \Delta u_1(\varphi, \theta) \|$$

with
$S_1$: rotation / shift vector

Ideally, both vectors intersect at one point. In reality, however, at least one more additional shift of the rotation point can be made, since environmental conditions, imperfections of the system itself and of the measuring system can lead to the vectors not intersecting.

To further improve the determination of the position of the disturbance, another criterion can be used. The maximum deviation of the natural frequencies of the system due to the fault.

This gives the following condition:

$$\max_{\varphi,\theta} \|\Delta \boldsymbol{u_2}(\varphi,\theta)\| = \max_{\alpha,\beta} \left\| \left(\boldsymbol{G^{-1}}_{r,\mathrm{Ref}} - \boldsymbol{G^{-1}}_{r,\mathrm{Fehler}}\right) * \boldsymbol{y}_r(\varphi,\theta) \right\| = y_{r,2}$$

Again, the center of rotation can be moved again to determine another vector

$$\Delta \boldsymbol{u_3}(\varphi,\theta) = \left\{\left(\boldsymbol{G^{-1}}_{r,\mathrm{Ref}} + S_1 * \boldsymbol{G^{-1}}_{t,\mathrm{Ref}}\right) - \left(\boldsymbol{G^{-1}}_{r,\mathrm{Fehler}} + S_1 * \boldsymbol{G^{-1}}_{t,\mathrm{Fehler}}\right)\right\} * \boldsymbol{y}_r(\varphi,\theta)$$

from which in turn the maximum of the deviation can be determined.

$$\max_{\varphi,\theta} \|\Delta \boldsymbol{u_3}(\varphi,\theta)\| = y_{r,3}$$

However, the found vectors $y_{r,2}$ and $y_{r,3}$ no longer pass through the disturbance but are orthogonal to it. That means $y_r$ spans with $y_{r,2}$ the plane $E_1$ and $y_{r,1}$ spans with $y_{r,3}$ the plane $E_2$.
On the intersection line $k_1$ of the two planes $E_1$ and $E_2$ thus generated, again, the sought fault is located.
If the resulting vectors do not intersect in exactly one point, which is possible in reality, a corresponding further optimization can follow the calculations of the directions / vectors of the disturbances in order to estimate the coordinates of the disturbance as exactly as possible.

BRIEF DESCRIPTION OF THE FIGURES

The enclosed figures show in purely schematic manner:

Figure 1 a schematic for illustrating the underlying principle of the present invention in two-dimensional representation,

Figure 2 a representation of the principle of the present invention for the three-dimensional case,

Figure 3 a representation of a schematic relating to the evaluation of the captured vibration behaviour, and

Figure 4 a representation of the method according to the invention for localizing an assembly error in the case of repeated performance of the method with different centres of mass of the structural element to be investigated.

EXEMPLARY EMBODIMENTS

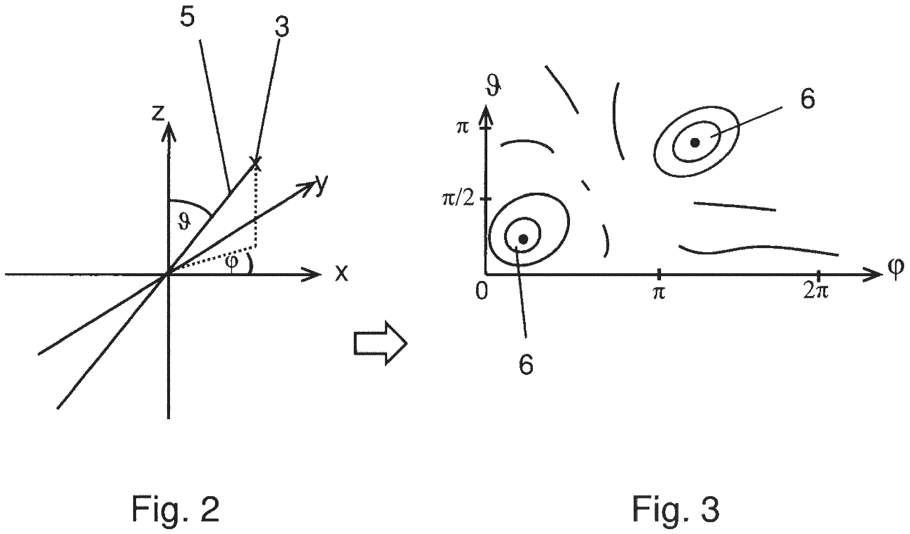

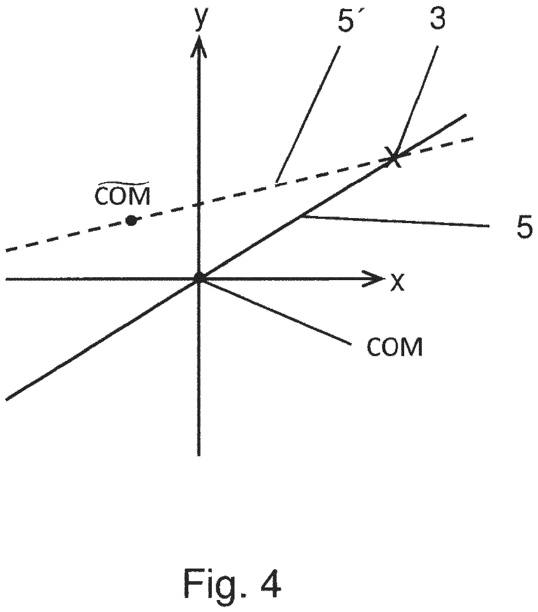

Further advantages, characteristics and features of the present invention will become clear in the following detailed description of exemplary embodiments, although the invention is not limited to said exemplary embodiments.

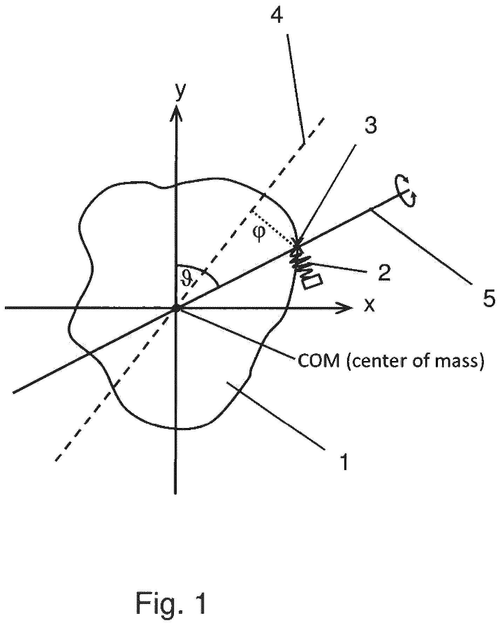

Figure 1 shows, in a two-dimensional representation, a structural element 1, for example a carrier frame for optical components of an EUV projection exposure apparatus, that for illustrating the arbitrary form of the structural element 1 is depicted as an arbitrary rigid body. An extrinsic structural element 2 rests against the structural element 1 at the resting point 3. Upon vibration about the axis of rotation 4, a strong influence acts on the vibration behaviour of the structural element 1 about the axis of rotation 4 due to the distance p of the resting point 3 from the axis of rotation 4. However, when observing a vibration about the axis of rotation 5, which extends through the resting point 3 of the extrinsic structural element 2 at the structural element 1 and the centre of mass of the structural element 1, the influence on the vibration behaviour of the structural element 1 about the axis of rotation 5 becomes minimum.
This is also illustrated by Figure 2 for the three-dimensional case, wherein the three-dimensional space is defined by the coordinate system x, y and z. In the case of an axis of rotation 5 that extends through the location of the assembly error 3, the influence on the rotational vibration about the axis of vibration 5 is minimum. The axis of vibration 5 is characterized by the spherical coordinates $\varphi$ and d. In a representation in a schematic in accordance with Figure 3, in which the deviation of the captured vibration behaviour from a reference behaviour at the different axes of rotation is plotted over the spherical coordinates $(\varphi, \vartheta)$, it can be seen that two minima 6 which define the straight line through the axis of rotation $(\varphi, \vartheta)$ and $(\varphi + \pi, \vartheta + \pi)$ occur.
Since the only thing known when determining the position of the assembly error with respect to an axis of rotation is that the assembly error can be located on said axis of rotation, but it is not known where on said axis the assembly error is located, the method can be performed, as is shown in Figure 4, for at least two positions of the centre of mass or fictitious positions of the centre of mass of the structural element, wherein the ascertained axes of rotation 5 and 5' for the two positions of the centre of mass indicate in each case that the position of the assembly error 3 is on said axes of rotation 5 or 5'. For a more accurate localization, the point of intersection of the axes of rotation 5 and 5' can then be determined to accurately localize the position 3 of the assembly error.

Although the present invention has been described in detail by way of the exemplary embodiments, it is obvious to a person skilled in the art that the invention is not restricted to these exemplary embodiments but rather that modifications are possible such that individual features can be omitted or different types of combinations of features can be implemented, as long as there is no departure from the scope of protection of the appended claims. The present disclosure includes all combinations of the individual features presented.

LIST OF REFERENCE SIGNS

| | |
|---|---|
| 1 | structural element |
| 2 | extrinsic structural element |
| 3 | location of the assembly error |
| 4 | axis of rotation |
| 5, 5' | axis of rotation |
| 6 | minimum |

**Claims**

1. Method for localizing assembly errors during the arrangement and/or the assembly of structural elements of microlithographic projection exposure apparatuses, wherein the method comprises the following steps:

   a) exciting the structural element to be investigated to vibrations with respect to axes of vibration in at least three independent spatial directions and capturing the vibration behaviour of the excited structural element,
   b) comparing the captured vibration behaviour to a reference behaviour of the correctly mounted structural element and determining whether a deviation that exceeds a determined limit value has occurred, and
   c1) repeatedly performing steps a) and b), wherein during the repeated performance of steps a) and b), an excitation of the structural element to be investigated to vibrations with respect to axes of vibration in at least three independent spatial directions that differ from the previous axes are performed, and identifying the excited axes of vibration having the minimum and/or maximum deviation from the reference behaviour, and localizing an assembly error on the basis of the identified axes of vibration,
   and/or
   c2) mathematically evaluating the captured vibration behaviour obtained in step a) with respect to a plurality of fictitious axes of vibration being different to the axes of vibration in step a), and identifying the fictitious axis of vibration having the minimum and/or maximum deviation from the reference behaviour, and localizing an assembly error on the basis of the identified fictitious axis of vibration.

2. Method according to Claim 1,
   **characterized in that**
   the excitation to vibrations comprises excitation to rotational vibrations about at least one axis of rotation, preferably about three axes of rotation in three independent spatial directions.

3. Method according to one of the preceding claims,
   **characterized in that**
   the excitation to vibrations comprises excitation to translational vibrations in at least one spatial direction, preferably in a plurality of independent spatial directions.

4. Method according to one of the preceding claims,
   **characterized in that**
   the plurality of the fictitious axes of vibration are defined by axes that extend through the centre of mass of the structural element under investigation and have spherical coordinates with an azimuth angle $\varphi$ between 0 and $2\pi$ and a polar angle $\vartheta$ between 0 and $2\pi$, wherein azimuth angle $\varphi$ and polar angle $\vartheta$ vary in stepwise fashion with a uniform distance between 0 and $2\pi$.

**5.** Method according to one of the preceding claims,
**characterized in that**
the evaluation of the captured vibration behaviour is performed with respect to a plurality of fictitious axes of rotation.

**6.** Method according to one of the preceding claims,
**characterized in that**
the evaluation of the captured vibration behaviour is performed with respect to a plurality of fictitious axes of translation.

**7.** Method according to one of the preceding claims,
**characterized in that**
the method having steps a) and b) and c1) and/or c2) is run through at least a second time, wherein in the second run-through or in further run-throughs, the position of the centre of mass of the structural element to be investigated is changed by adding or removing mass, or the effective point of attack of the forces for the vibration excitation is changed by superposing excitation forces.

**8.** Method according to one of the preceding claims,
**characterized in that**
the excitation to vibrations is effected over a frequency range.

**9.** Method according to one of the preceding claims,
**characterized in that**
the ratio of the amplitude of the captured vibration behaviour at a specific frequency to the amplitude of the reference behaviour at said frequency is formed as a measure for the deviation of the captured vibration behaviour from the reference behaviour.

**10.** Computer program comprising instructions that, upon execution of the program by
a control unit of a microlithographic projection exposure apparatus cause the latter to perform the method according to one of the preceding claims.

**11.** Microlithographic projection exposure apparatus having a control unit, in which a computer program according to Claim 10 is executed or a method according to one of Claims 1 to 9 is performed.

**Patentansprüche**

**1.** Verfahren zum Lokalisieren von Zusammenbaufehlern während der Anordnung und/oder des Zusammenbaus von Strukturelementen von mikrolithografischen Projektionsbelichtungsvorrichtungen, wobei das Verfahren die folgenden Schritte umfasst:

a) Anregen des zu untersuchenden Strukturelements zu Schwingungen in Bezug auf Schwingungsachsen in mindestens drei unabhängigen räumlichen Richtungen und Aufnehmen des Schwingungsverhaltens des angeregten Strukturelements,
b) Vergleichen des aufgenommenen Schwingungsverhaltens mit einem Referenzverhalten des korrekt angebrachten Strukturelements und Bestimmen, ob eine Abweichung, die einen bestimmten Grenzwert überschreitet, aufgetreten ist,
und
c1) wiederholt Ausführen der Schritte a) und b), wobei während der wiederholten Ausführung der Schritte a) und b) eine Anregung des zu untersuchenden Strukturelements zu Schwingungen in Bezug auf Schwingungsachsen in mindestens drei unabhängigen räumlichen Richtungen, die von den vorherigen Achsen verschieden sind, ausgeführt wird, und Identifizieren der angeregten Schwingungsachsen mit der minimalen und/oder maximalen Abweichung von dem Referenzverhalten und Lokalisieren eines Zusammenbaufehlers anhand der identifizierten Schwingungsachsen,
und/oder
c2) mathematisch Beurteilen des aufgenommenen Schwingungsverhaltens, das in Schritt a) erhalten wurde, in Bezug auf mehrere fiktive Schwingungsachsen, die von den Schwingungsachsen in Schritt a) verschieden sind, und Identifizieren der fiktiven Schwingungsachsen mit der minimalen und/oder maximalen Abweichung von dem Referenzverhalten und Lokalisieren eines Zusammenbaufehlers anhand der identifizierten fiktiven Schwingungsachsen.

**2.** Verfahren nach Anspruch 1,
**dadurch gekennzeichnet, dass**
die Anregung zu Schwingungen eine Anregung zu Rotationsschwingungen um mindestens eine Rotationsachse, vorzugsweise um drei Rotationsachsen in drei unabhängigen räumlichen Richtungen umfasst.

**3.** Verfahren nach einem der vorhergehenden Ansprüche,
**dadurch gekennzeichnet, dass**
die Anregung zu Schwingungen eine Anregung zu Translationsschwingungen in mindestens einer räumlichen Richtung, vorzugsweise in mehreren unabhängigen räumlichen Richtungen umfasst.

**4.** Verfahren nach einem der vorhergehenden Ansprüche,
**dadurch gekennzeichnet, dass**
die mehreren fiktiven Schwingungsachsen durch Achsen definiert sind, die sich durch den Schwerpunkt des zu untersuchenden Strukturelements erstrecken und sphärische Koordinaten mit einem Azimutwinkel $\varphi$ zwischen 0 und $2\pi$ und einem Polarwinkel $\vartheta$ zwischen 0 und $2\pi$ besitzen, wobei der Azimutwinkel $\varphi$ und der Polarwinkel $\vartheta$ schrittweise mit einem einheitlichen Abstand zwischen 0 und $2\pi$ variieren.

**5.** Verfahren nach einem der vorhergehenden Ansprüche,
**dadurch gekennzeichnet, dass**
die Beurteilung des aufgenommenen Schwingungsverhaltens in Bezug auf mehrere fiktive Rotationsachsen ausgeführt wird.

**6.** Verfahren nach einem der vorhergehenden Ansprüche,
**dadurch gekennzeichnet, dass**
die Beurteilung des aufgenommenen Schwingungsverhaltens in Bezug auf mehrere fiktive Translationsachsen ausgeführt wird.

**7.** Verfahren nach einem der vorhergehenden Ansprüche,
**dadurch gekennzeichnet, dass**
das Verfahren mit den Schritten a) und b) und c1) und/oder c2) zumindest ein zweites Mal durchlaufen wird, wobei in dem zweiten Durchlauf oder in weiteren Durchläufen die Position des Schwerpunkts des zu untersuchenden Strukturelements durch Hinzufügen oder Entfernen von Masse geändert wird oder der effektive Angriffspunkt der Kräfte für die Schwingungsanregung durch Überlagern von Anregungskräften geändert wird.

**8.** Verfahren nach einem der vorhergehenden Ansprüche,
**dadurch gekennzeichnet, dass**
die Anregung zu Schwingungen über einen Frequenzbereich ausgeführt wird.

**9.** Verfahren nach einem der vorhergehenden Ansprüche,
**dadurch gekennzeichnet, dass**
das Verhältnis der Amplitude des aufgenommenen Schwingungsverhaltens bei einer spezifischen Frequenz zu der Amplitude des Referenzverhaltens bei der Frequenz als ein Maß für die Abweichung des aufgenommenen Schwingungsverhaltens von dem Referenzverhalten gebildet wird.

**10.** Computerprogramm, das Anweisungen umfasst, die bei Ausführung des Programms durch eine Steuereinheit einer mikrolithografischen Projektionsbelichtungsvorrichtung bewirken, dass Letztere das Verfahren nach einem der vorhergehenden Ansprüche ausführt.

**11.** Mikrolithografische Projektionsbelichtungsvorrichtung mit einer Steuereinheit, in der ein Computerprogramm nach Anspruch 10 ausgeführt wird oder ein Verfahren nach einem der Ansprüche 1 bis 9 ausgeführt wird.

**Revendications**

**1.** Procédé de localisation d'erreurs d'assemblage durant l'agencement et/ou l'assemblage d'éléments structuraux d'appareils d'exposition par projection microlithographique, le procédé comprenant les étapes suivantes :

a) excitation de l'élément structural à étudier jusqu'aux vibrations par rapport à des axes de vibration dans au moins trois directions spatiales indépendantes et capture du comportement vibratoire de l'élément structural excité,

b) comparaison du comportement vibratoire capturé à un comportement de référence de l'élément structural correctement monté et détermination s'il s'est produit un écart qui dépasse une valeur limite déterminée, et

c1) répétition de la réalisation des étapes a) et b), durant la réalisation répétée des étapes a) et b), une excitation de l'élément structural à étudier jusqu'au vibrations par rapport à des axes de vibration dans au moins trois directions spatiales indépendantes qui diffèrent des axes précédents étant réalisée, et identification des axes de vibration excités présentant l'écart minimal et/ou maximal par rapport au comportement de référence, et localisation d'une erreur d'assemblage sur la base des axes de vibration identifiés, et/ou

c2) évaluation mathématique du comportement vibratoire capturé obtenu à l'étape a) par rapport à une pluralité d'axes de vibration fictifs qui sont différents des axes de vibration à l'étape a), et identification des axes de vibration fictifs présentant l'écart minimal et/ou maximal par rapport au comportement de référence, et localisation d'une erreur d'assemblage sur la base des axes de vibration fictifs identifiés.

2. Procédé selon la revendication 1,
**caractérisé en ce que**
l'excitation jusqu'aux vibrations comprend l'excitation jusqu'aux vibrations de rotation autour d'au moins un axe de rotation, de préférence autour de trois axes de rotation dans trois directions spatiales indépendantes.

3. Procédé selon l'une des revendications précédentes, **caractérisé en ce que**
l'excitation jusqu'aux vibrations comprend l'excitation jusqu'aux vibrations de translation dans au moins une direction spatiale, de préférence dans une pluralité de directions spatiales indépendantes.

4. Procédé selon l'une des revendications précédentes, **caractérisé en ce que**
la pluralité d'axe de rotation fictifs sont définis par des axes qui passent par le centre de masse de l'élément structural à l'étude et qui possèdent des coordonnées sphériques avec un angle d'azimut $\varphi$ compris entre 0 et $2\pi$ et un angle polaire $\vartheta$ compris entre 0 et 2n, l'angle d'azimut $\varphi$ et l'angle polaire $\vartheta$ variant par paliers avec une distance uniforme comprise entre 0 et 2n.

5. Procédé selon l'une des revendications précédentes, **caractérisé en ce que**
l'évaluation du comportement vibratoire capturé est réalisée par rapport à une pluralité d'axes de rotation fictifs.

6. Procédé selon l'une des revendications précédentes, **caractérisé en ce que**
l'évaluation du comportement vibratoire capturé est réalisée par rapport à une pluralité d'axes de translation fictifs.

7. Procédé selon l'une des revendications précédentes, **caractérisé en ce que**
le procédé comportant les étapes a) et b) et c1) et/ou c2) est exécuté au moins une deuxième fois, lors de la deuxième exécution ou lors d'exécutions supplémentaires, la position du centre de masse de l'élément structural à étudier étant modifiée par ajout ou retrait de masse, ou le point d'attaque effectif des forces pour l'excitation jusqu'aux vibrations étant modifié par superposition de forces d'excitation.

8. Procédé selon l'une des revendications précédentes, **caractérisé en ce que**
l'excitation jusqu'aux vibrations s'effectue sur une plage de fréquences.

9. Procédé selon l'une des revendications précédentes, **caractérisé en ce que**
le rapport de l'amplitude du comportement vibratoire capturé à une fréquence particulière sur l'amplitude du comportement de référence à ladite fréquence est établi pour former une mesure pour l'écart du comportement vibratoire capturé par rapport au comportement de référence.

10. Programme d'ordinateur comprenant des instructions qui, lorsque le programme est exécuté par une unité de commande d'un appareil d'exposition par projection microlithographique, amènent ce dernier à réaliser le procédé selon l'une des revendications précédentes.

11. Appareil d'exposition par projection microlithographique doté d'une unité de commande dans laquelle est exécuté un programme d'ordinateur selon la revendication 10 ou est réalisé un procédé selon l'une des revendications 1 à 9.

Fig. 1

Fig. 2

Fig. 3

EP 3 601 988 B1

Fig. 4

EP 3 601 988 B1